# EUROPEAN PATENT APPLICATION

(11) **EP 4 847 452 A1**
(43) Date of publication of application: **02.12.2026**
(21) Application number: 25767653.6
(22) Date of filing: 03.03.2025
(51) Int. Cl.: C01G 7/00, C01G 3/00, C01G 5/00, C23C 14/06, C30B 29/38

(54) **NITRIDE MATERIAL, AND DIODE AND TRANSISTOR USING SAME**

(30) Priority: 04.03.2024 JP 2024031899
(71) Applicant: National Institute of Advanced Industrial Science and Technology, Tokyo 100-8921 (JP)
(72) Inventor: ANGGRAINI, Sri Ayu, Tsukuba-shi Ibaraki 305-8560 (JP); HIRATA, Kenji, Tsukuba-shi Ibaraki 305-8560 (JP); OHMAGARI, Shinya, Tsukuba-shi Ibaraki 305-8560 (JP); UEHARA, Masato, Tsukuba-shi Ibaraki 305-8560 (JP); YAMADA, Hiroshi, Tsukuba-shi Ibaraki 305-8560 (JP); AKIYAMA, Morito, Tsukuba-shi Ibaraki 305-8560 (JP)
(74) Representative: Groth, Wieland
(86) International application number: PCT/JP2025/007571
(87) International publication number: WO 2025/187656

(57) **Abstract**

[Object] To provide a nitride material obtained by doping impurities into AlN, particularly a nitride material having an electrical resistivity of 1.0 Ω·cm or lower, as well as a diode and a transistor using the nitride material.

[Solution] A nitride material is represented by a chemical formula A1_{α1}B1_{β1}Al_{1-α1-β1}N or a chemical formula A1_{α1}B1_{β1}Ga_{1-α1-β1}N, α1 and β1 satisfying the following equation (1), or represented by a chemical formula B2_{β2}Al_{1-β2}N or a chemical formula B2_{β2}Ga_{1-β2}N, β2 satisfying the following equation (2), B1 and B2 including a monovalent element, $0 < α 1 / β 1 < 6$ (1), $0 < β 2 < 0.52$ (2), (0 < α1 < 1, 0 < β1 < 1, Al is at least one of Mg and Zn, and B1 and B2 are at least one of Au, Ag, and Cu).

## Description

### Technical Field

The present invention relates to a nitride material, particularly a nitride material having electrical conductivity, and a diode and transistor using the nitride material.

### Background Art

Nitride semiconductor materials, represented by AlN, GaN, InN, BN, and their mixed crystals, are characterized by having a wide band gap. Such a semiconductor material with a wide band gap is considered to be excellent for high-temperature and high-voltage operation and suitable for high-power and high-frequency applications and use in high-temperature environments. In particular, AlN has an especially wide band gap and is regarded as a promising material.

As such a semiconductor material, a material has been proposed which is composed of a plurality of AlₓGa₁₋ₓN layers with different Ga concentrations, and in which an Al concentration x in each of the AlₓGa₁₋ₓN layers is decreased such that a lattice constant in a c-axis direction increases in the +c-axis direction (see Patent Literature 1).

Similarly, as such a semiconductor material, a material has been proposed in which a chemical composition (mixing GaN in a range of a few percent to 30% relative to AlN) is spatially changed (see Non-Patent Literature 1).

In addition, it has been reported that control of a p-type electrical conduction of Mg-doped Al is considered hopeless (see Non-Patent Literature 2).

### Citation List

### Patent Literature

Patent Literature 1: Japanese Unexamined Patent Application Publication No. 2023-111945

### Non-Patent Literature

Non-Patent Literature 1: Jun Suda et al., "Achieving Ideal Properties with Aluminum Nitride (AlN)-Based Ultra-Wide Band Gap Semiconductor pn Junctions", [online], December 14, 2023, PRTIMES, [Retrieved February 18, 2024], Internet <https://prtimes.jp/main/html/rd/p/000000109.000079452.html>
Non-Patent Literature 2: Proceedings of the 84th JSAP Autumn Meeting, 22p-B101-15, "On the substitutional Mg acceptor binding energy of AlN: experimental aspects," Kyoto University

### Summary of Invention

### Technical Problem

However, the semiconductor material disclosed in Patent Literature 1 has a problem: although the material is designed to facilitate injection of electrons into AlN, it is not a p-type semiconductor material.

In addition, the semiconductor material disclosed in Non-Patent Literature 1 has a problem: although a p-type semiconductor material can be produced through impurity doping, insufficient thermal energy at room temperature prevents electron transfer to an acceptor, causing the semiconductor material to exhibit insufficient electrical conductivity of a p-type semiconductor material.

In view of the circumstances described above, the present invention aims to provide a nitride material obtained by doping impurities into aluminum nitride (AlN) or gallium nitride (GaN), particularly a nitride material having low electrical resistivity (electrical conductivity) and exhibiting semiconductor properties, and a diode and transistor using the nitride material.

Here, International Publication No. 2020/170610 discloses Mg_{α1}Au_{β1}Al_{1-α1-β1}N which will be described later, but it is described as exhibiting insulating properties. Further, the nitride material described in this publication is obtained through numerical calculations, and there is a problem regarding whether the valence (valency) of Au used in the calculations is correct. As will be described in detail later, B1 or B2 contained in the nitride material according to the present invention (A1_{α1}B1_{β1}A1_{1-α1-β1}N, A1_{α1}B1_{β1}Ga_{1-α1-β1}N, B2_{β2}Al_{1-β2}N, or B2_{β2}Ga_{1-β2}N) includes at least a monovalent element, and furthermore, as mentioned above, the nitride material according to the present invention has electrical conductivity (for example, an electrical resistivity of 10⁷ Ω·cm or lower). Therefore, the present invention is entirely different from the invention described in International Publication No. 2020/170610.

### Solution to Problem

As a result of persistent research into the aforementioned problems, the inventors of the present invention have discovered the following revolutionary nitride material.

A first aspect of the present invention for solving the above-mentioned problems is a nitride material represented by a chemical formula A1_{α1}B1_{β1}Al_{1-α1-β1}N or a chemical formula A1_{α1}B1_{β1}Ga_{1-α1-β1}N, α1 and β1 satisfying the following equation (1), or represented by a chemical formula B2_{β2}Al_{1-β2}N or a chemical formula B2_{β2}Ga_{1-β2}N, β2 satisfying the following equation (2), B1 and B2 including a monovalent element, $0 < α 1 + β 1 < 1$ (1), $0 < β 2 < 1$ (2), (0 < α1 < 1, 0 < β1 < 1, A1 is at least one of Mg and Zn, and B1 and B2 are at least one of Au, Ag, and Cu).

Here, "monovalent element" refers to an element with a valence of 1. The valence of B1 can be detected, for example, by X-ray photoelectron spectroscopy (XPS), X-ray absorption spectroscopy (XANES), TEM-EELS, or the like.

According to the first aspect, the nitride material can be provided that has a low electrical resistivity and exhibits semiconductor properties in which electrical conduction is primarily carried out by holes (for example, high temperature (for example, 100°C or higher) operation and enabling provision of a diode exhibiting a high dielectric breakdown field strength (for example, 2 MV/cm or higher)).

A second aspect of the present invention is the nitride material according to the first aspect, in which α1 and β1 satisfy the following equation (3), and β2 satisfies the following equation (4), $0 < α 1 / β 1 < 6$ (3), $0 < β 2 < 0.52$ (4).

According to the second aspect, the nitride material can be provided that has a lower electrical resistivity and exhibits semiconductor properties in which electrical conduction is primarily carried out by holes (for example, high temperature (for example, 100°C or higher) operation and enabling provision of a diode exhibiting a high dielectric breakdown field strength (for example, 2 MV/cm or higher)).

A third aspect of the present invention is the nitride material according to the first aspect, in which B1 with a valence of 1 is contained in the highest amount compared to B1 with a valence other than 1, or B2 with a valence of 1 is contained in the highest amount compared to B2 with a valence other than 1.

According to the third aspect, the nitride material that has a lower electrical resistivity and exhibits semiconductor properties can be provided.

A fourth aspect of the present invention is the nitride material according to the first aspect, in which a crystal structure is a wurtzite crystal structure.

According to the fourth aspect, the nitride material that has a lower electrical resistivity and exhibits semiconductor properties can be provided.

A fifth aspect of the present invention is the nitride material according to the first aspect, in which α1 and β1 satisfy the following equations (5) and (6), $1 \leq α 1 / β 1 \leq 5$ (5), $0 < α 1 + β 1 \leq 0.3$ (6).

According to the fifth aspect, the nitride material that has a still lower electrical resistivity and exhibits semiconductor properties can be provided.

A sixth aspect of the present invention is the nitride material according to any one of the first to fifth aspects, in which an electrical resistivity is 10.0 Ω·cm or lower.

According to the sixth aspect, the nitride material that exhibits higher semiconductor properties can be provided.

A seventh aspect of the present invention is the nitride material according to any one of the first to fifth aspects, in which an electrical resistivity is 1.0 Ω·cm or lower.

According to the seventh aspect, the nitride material that exhibits still higher semiconductor properties can be provided.

An eighth aspect of the present invention is a diode including the nitride material according to the first aspect and an n-type semiconductor material joined to the nitride material.

According to the eighth aspect, the diode exhibiting a high dielectric breakdown field strength (for example, 2 MV/cm or higher) can be provided.

A ninth aspect of the present invention is a transistor including the nitride material according to the first aspect and two n-type semiconductor materials joined to each other, or including an n-type semiconductor material and two nitride materials according to the first aspect joined to this n-type semiconductor material.

Here, "n-type semiconductor material" refers to a semiconductor material in which electrical conduction occurs due to free electrons carrying a negative charge.

According to the ninth aspect, the transistor exhibiting a high dielectric breakdown field strength (for example, 2 MV/cm or higher) can be provided.

Note that the specification of Japanese Patent Application No. 2024-31899 is incorporated herein by reference as part of this specification.

### Brief Description of Drawings

[Fig. 1] Fig. 1 is a table showing the composition and electrical resistivity of examples of Embodiment 1.
[Fig. 2] Fig. 2 is a graph showing measurement results from an X-ray diffractometer (XRD) for Examples 1-1 to 1-3.
[Fig. 3] Fig. 3 is a diagram showing a relationship between binding energy and intensity in Examples 1 and 3 of Embodiment 1.
[Fig. 4] Fig. 4 is a diagram showing a relationship between binding energy and intensity of the following: Mg_{0.050}Au_{0.037}Al_{0.913}N, Mg_{0.073}Au_{0.036}Al_{0.891}N, Mg_{0.101}Au_{0.033}Al_{0.866}N, and Mg_{0.388}Au_{0.081}Al_{0.531}N.
[Fig. 5] Fig. 5 is a diagram showing a relationship between binding energy and intensity of Mg_{0.050}Au_{0.037}Al_{0.913}N.
[Fig. 6] Fig. 6 is a diagram showing a band gap of Mg_{0.0625}Au_{0.0625}Al_{0.875}N calculated using VASP.
[Fig. 7] Fig. 7 is a schematic diagram of a diode manufactured using the nitride material according to Embodiment 1.
[Fig. 8] Fig. 8 is a graph showing a relationship between voltage and current for a diode manufactured using Mg_{0.06}Cu_{0.04}Al_{0.90}N.
[Fig. 9] Fig. 9 is a graph showing a relationship between voltage and current for a diode manufactured using Zn_{0.02}Ag_{0.02}Al_{0.96}N.
[Fig. 10] Fig. 10 is a table showing the composition and electrical resistivity of examples of Embodiment 2.
[Fig. 11] Fig. 11 is a graph showing measurement results from the X-ray diffractometer (XRD) for Example 2-1 (Au_{0.02}Al_{0.98}N), Au_{0.05}Al_{0.95}N, and Au_{0.14}Al_{0.86}N.
[Fig. 12] Fig. 12 is a diagram showing a relationship between binding energy and intensity in Example 2-1.
[Fig. 13] Fig. 13 is a diagram showing a relationship between binding energy and intensity in Example 2-2.
[Fig. 14] Fig. 14 is a diagram showing a band gap of Au_{0.0625}Al_{0.9375}N calculated using VASP.

### Description of Embodiments

Embodiments of a nitride material according to the present invention will be described below with reference to the accompanying drawings. However, note that the present invention is not limited to the following embodiments.

### (Embodiment 1)

A nitride material of the present embodiment is represented by a chemical formula A1_{α1}B1_{β1}Al_{1-α1-β1}N or A1_{α1}B1_{β1}Ga_{1-α1-β1}N, where α1 and β1 satisfy the following equation (1): $0 < α 1 + β 1 < 1$ (1),

(0 < α1 < 1, 0 < β1 < 1, A1 is at least one of Mg and Zn, and B1 is at least one of Au, Ag, and Cu.)

In addition, this nitride material contains B1 with a valence of 1. The valence of B1 can be detected using X-ray photoelectron spectroscopy (XPS) or the like.

A nitride material having such a composition has an electrical resistivity of 1.47×10⁻⁶ Ω·cm or higher and 10.0 Ω·cm or lower (that is, having electrical conductivity) and exhibits semiconductor properties in which electrical conduction is primarily carried out by holes.

Further, it is preferable that α1 and β1 satisfy the following equation (3): $0 < α 1 / β 1 < 6$ (3). Such a nitride material has a lower electrical resistivity and exhibits high semiconductor properties.

Furthermore, among nitride materials having such a composition, those with an electrical resistivity of 1.47×10⁻⁶ Ω·cm or higher and 1.0 Ω·cm or lower are preferred because they exhibit higher semiconductor properties.

In addition, it is preferable that a crystal structure of the nitride material of the present embodiment is a wurtzite crystal structure. A material having a wurtzite crystal structure has a lower electrical resistivity and exhibits high semiconductor properties.

Here, B1 may include an element with a valence other than 1 (for example, valences of 0, 2, and 3), but a nitride material is preferred in which the content of monovalent B1 is the highest compared to that of element with a valence other than 1. A nitride material with such a composition has a lower electrical resistivity and exhibits higher semiconductor properties.

Further, although a ratio of α1 and β1 is not particularly limited, it is more preferable that α1 and β1 satisfy the following equations (5) and (6). $1 \leq α 1 / β 1 \leq 5$ (5) $0 < α 1 + β 1 \leq 0.3$ (6) A nitride material satisfying these equations has a lower electrical resistivity and exhibits particularly high semiconductor properties.

Next, a method for producing the above-described nitride materials will be described. These nitride materials can be produced using a producing method such as general physical vapor deposition (PVD) (for example, sputtering, molecular beam epitaxy (MBE), and vapor deposition) and chemical vapor deposition (CVD). Specifically, for example, they can be produced by simultaneously sputtering a target composed of B1 (Au, Ag, Cu), a target composed of A1 (Mg, Zn), and a target composed of aluminum (Al) or gallium (Ga) onto a substrate (for example, a silicon (Si) substrate), under a nitrogen gas (N₂) atmosphere, or under a mixed atmosphere of nitrogen gas (N₂) and argon gas (Ar) (gas pressure of 1 Pa or lower). Note that alloys containing B1, A1, and Al or Ga in predetermined ratios may be used as targets.

### (Examples)

Using the following apparatus, sputtering targets, and the like, a plurality of thin films of the nitride material according to the present embodiment, having a thickness of 0.4 to 1.5 µm, were prepared on an n-type silicon substrate having a specific electrical resistance of 0.02 Ωcm.
Multi-target simultaneous sputtering deposition apparatus (manufactured by EIKO ENGINEERING, LTD.)
Au sputtering target material (concentration: 99.9%)
Ag sputtering target material (concentration: 99.9%)
Cu sputtering target material (concentration: 99.9%)
Mg sputtering target material (concentration: 99.99%)
Zn sputtering target material (concentration: 99.99%)
Al sputtering target material (concentration: 99.999%)
GaN sputtering target material (concentration: 99.99%)
Gas: Gas mixture of nitrogen (purity: 99.99995% or higher) and argon gas (purity: 99.9999% or higher) (mixture ratio 50:50)
Substrate heating temperature: 500°C

The film deposition experiment was performed after reducing the pressure inside the sputtering chamber to a high vacuum of 10⁻⁵ Pa or lower using a vacuum pump. Furthermore, to prevent contamination by impurities such as oxygen, the target surface was cleaned immediately after target installation and immediately before each film deposition experiment.

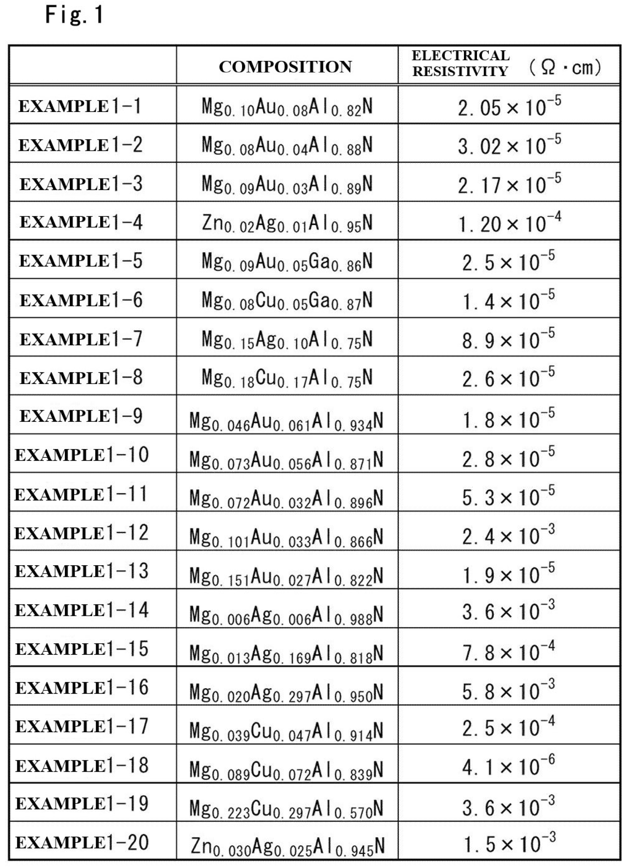

Fig. 1 shows the composition and electrical resistivity of each of the obtained nitride materials. From this diagram, it was found that the electrical resistivity of each of the nitride materials is 1.0 Ω·cm or lower.

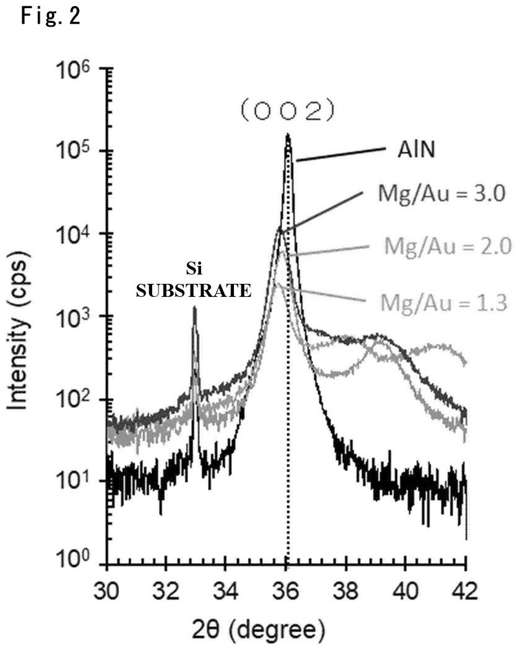

Further, Fig. 2 shows measurement results from the X-ray diffractometer (XRD) for Examples 1-1 to 1-3. As can be seen from this diagram, it was found that the respective nitride materials of Examples 1-1 to 1-3 have a wurtzite crystal structure.

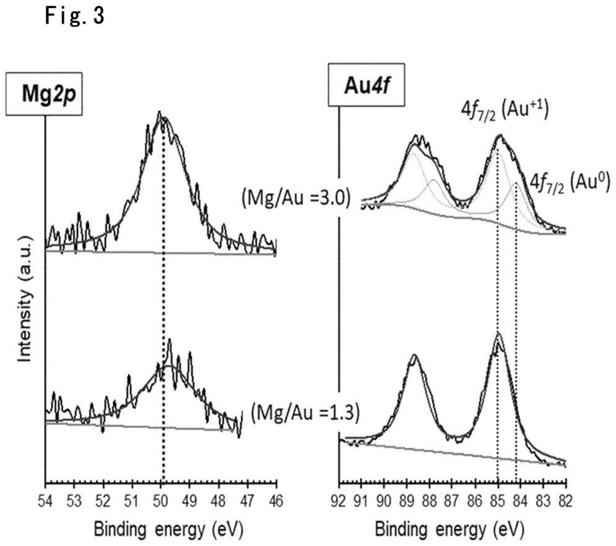

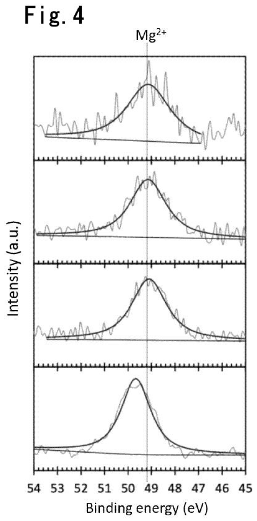

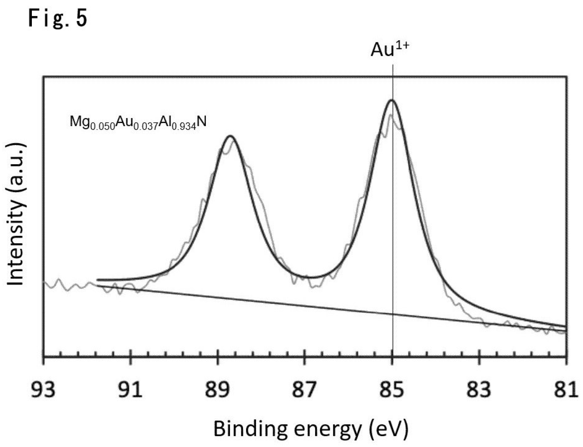

Furthermore, Fig. 3 shows a relationship between binding energy and intensity when the nitride materials of Examples 1-1 and 1-3 were measured using XPS (manufactured by Shimadzu/Kratos Analytical, AXIS-165). Additionally, Fig. 4 shows results of valence measurement for Mg in Mg_{0.050}Au_{0.037}Al_{0.913}N (top row), Mg_{0.073}Au_{0.036}Al_{0.891}N (second row from top), Mg_{0.101}Au_{0.033}Al_{0.866}N (third row from top), and Mg_{0.388}Au_{0.081}Al_{0.531}N (bottom row), using the X-ray diffractometer (XRD); and Fig. 5 shows a result of valence measurement for Au in Mg_{0.050}Au_{0.037}Al_{0.913}N. The peak shown in these diagrams indicates the binding energy of each of the elements. Further, from Figs. 3 and 4, the binding energy of Mg2p was found to match that of Mg having a valence of 2 (+2). Similarly, from Figs. 3 and 5, the binding energy of Au4f was found to match that of Au having a valence of 1 (+1). Therefore, the valence of Mg contained in the nitride materials of Examples 1-1 and 1-3, as well as in Mg_{0.050}Au_{0.037}Al_{0.913}N and Mg_{0.101}Au_{0.033}Al_{0.866}N, was found to be 2 (+2), and Au having a valence (valency) of 1 (+1) contained in the nitride materials of Examples 1-1 and 1-3, as well as in Mg_{0.050}Au_{0.037}Al_{0.913}N, was found to be in a greater amount than Au having a valence of zero (Au⁰) contained therein.

### <Band gap>

The band gap of the nitride material (Mg_{0.0625}Au_{0.0625}Al_{0.875}N) according to the present embodiment was calculated via simulation. For this simulation, the software Vienna Ab initio Simulation Package (VASP) was used, which employs a calculation method known as first-principles calculation. Here, the first-principles calculation is a general term for electronic state calculation methods which do not use fitting parameters or the like, and it is a method which allows an electronic state to be calculated using only the atomic number and coordinates of each atom constituting a unit cell, a molecule, or the like.

The simulation of the present embodiment used a wurtzite crystal structure of a supercell composed of 16 aluminum atoms and 16 nitrogen atoms, obtained by doubling a unit cell, which is composed of two aluminum atoms and two nitrogen atoms, along each of a, b, and c axes.

Calculations were performed employing the wurtzite crystal structure in which, within a unit cell composed of 16 Al atoms and 16 N atoms, one Al atom was replaced with an Mg atom and another Al atom was replaced with an Au atom. Then, for the model of this wurtzite crystal structure, the first-principles calculation was performed by simultaneously varying the atomic coordinates, cell volume, and cell shape to calculate an electronic state of a stable structure.

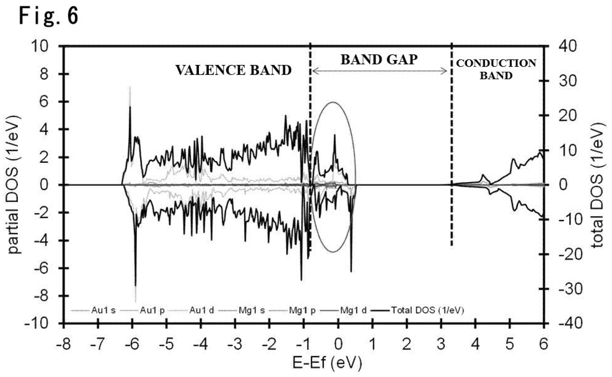

The results are shown in Fig. 6. Note that "E-Ef" on the horizontal axis of this diagram indicates energy levels relative to the Fermi energy (Ef). These results show that there is an acceptor level, which is the density of states (DOS) originating from impurities (Mg, Au), at an energy level slightly higher than a valence band of AIN.

It is known that in semiconductor materials in which electrical conduction is primarily carried out by holes, a DOS (acceptor level) originating from an impurity (an added element) is formed at an energy level slightly higher than the valence band. From this, it can be seen that the nitride material (Mg_{0.0625}Au_{0.0625}Al_{0.875}N) exhibits semiconductor properties.

### <p-type semiconductor>

The nitride material according to the present embodiment is produced by doping (adding) AlN or GaN, which is a base material, with at least one of Mg and Zn and at least one of Au, Ag, and Cu. That is, it is produced by doping a trivalent element Al or Ga contained in AlN or GaN, which is the base material, with at least one of divalent elements Mg and Zn and at least one of monovalent elements Au, Ag, and Cu. As a result, holes are generated, whereby the nitride material according to the present embodiment becomes a p-type semiconductor.

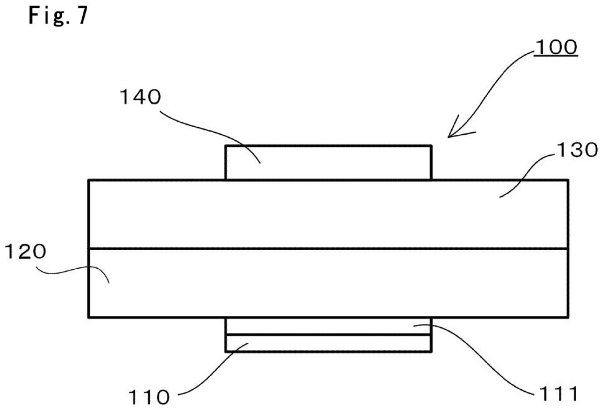

In practice, a diode 100 having a structure shown in Fig. 7 was manufactured. This diode 100 includes, from bottom to top, a lower electrode, an n-type Si film 120 having a film thickness of 635 µm, a thin film 130 of the nitride material according to the present embodiment (Mg_{0.06}Cu_{0.04}Al_{0.90}N or Zn_{0.02}Ag_{0.02}Al_{0.96}N) having a film thickness of 0.8 µm to 1.5 µm, and an Al thin film 140 having a film thickness of 80 nm. Note that the lower electrode includes an Au thin film 110 having a film thickness of 30 nm and a Ti thin film 111 having a film thickness of 10 nm formed on the Au thin film 110.

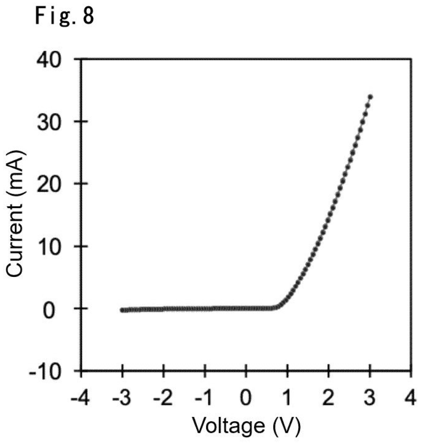

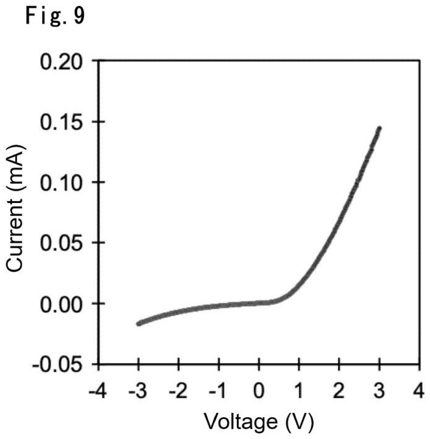

A relationship between voltage and current of these diodes was measured using a KEYSIGHT B2985A Electrometer/High resistance meter. The results are shown in Figs. 8 and 9. From Fig. 8, it was found that the corresponding diode functioned properly as a diode and Mg_{0.06}Cu_{0.04}Al_{0.90}N was a p-type semiconductor. From Fig. 9, it was found that the corresponding diode functioned properly as a diode and Zn_{0.02}Ag_{0.02}Al_{0.96}N was a p-type semiconductor.

### (Embodiment 2)

A nitride material of the present embodiment is represented by a chemical formula B2_{β2}Al_{1-β2}N or a chemical formula B2_{β2}Ga_{1-β2}N, where β2 satisfies the following equation (2): $0 < β 2 < 1$ (2). (B2 is at least one of Au, Ag, and Cu.)

A nitride material having such a composition has an electrical resistivity of 1.47×10⁻⁶ Ω·cm or higher and 10.0 Ω·cm or lower (that is, having electrical conductivity) and exhibits semiconductor properties in which electrical conduction is primarily carried out by holes. Note that, among nitride materials having such a composition, those with an electrical resistivity of 1.47×10⁻⁶ Ω·cm or higher and 1.0 Ω·cm or lower are preferred because they exhibit higher semiconductor properties.

Further, it is preferable that β2 satisfies the following equation (4): $0 < β 2 < 0.52$ (4). Such a nitride material has a lower electrical resistivity and exhibits high semiconductor properties. Note that β2 is more preferably in a range of 0 < β2 < 0.2. A nitride material in which β2 falls in this range will have a still lower electrical resistivity and exhibit higher semiconductor properties.

Furthermore, it is preferable that a crystal structure of the nitride material of the present embodiment is a wurtzite crystal structure. A material having a wurtzite crystal structure has a lower electrical resistivity and exhibits high semiconductor properties.

Here, B2 may include an element with a valence other than 1 (for example, valences of 0, 2, and 3), but a nitride material is preferred in which the content of monovalent B2 is the highest compared to that of element with a valence other than 1. A nitride material with such a composition has a lower electrical resistivity and exhibits higher semiconductor properties.

Next, a method for producing the above-described nitride materials will be described. These nitride materials can be produced using common producing methods such as sputtering and vapor deposition. Specifically, for example, they can be produced by simultaneously sputtering a target composed of B2 (Au, Ag, Cu) and a target composed of aluminum (Al) or gallium (Ga) onto a substrate (for example, a silicon (Si) substrate), under a nitrogen gas (N₂) atmosphere, or under a mixed atmosphere of nitrogen gas (N₂) and argon gas (Ar) (gas pressure of 1 Pa or lower). Note that alloys containing B2 and Al or Ga in predetermined ratios may be used as targets.

### (Examples)

Using the following apparatus, sputtering targets, and the like, thin films of the nitride material according to the present embodiment, having a thickness of 0.4 to 1.5 µm, were each prepared on an n-type silicon substrate having a specific electrical resistance of 0.02 Ωcm.
Multi-target simultaneous sputtering deposition apparatus (manufactured by EIKO ENGINEERING, LTD.)
Au sputtering target material (concentration: 99.9%)
Ag sputtering target material (concentration: 99.9%)
Cu sputtering target material (concentration: 99.9%)
Al sputtering target material (concentration: 99.999%)
GaN sputtering target material (concentration: 99.99%)
Gas: Gas mixture of nitrogen (purity: 99.99995% or higher) and argon gas (purity: 99.9999% or higher) (mixture ratio 50:50)
Substrate heating temperature: 500°C

The film deposition experiment was performed after reducing the pressure inside the sputtering chamber to a high vacuum of 10⁻⁵ Pa or lower using a vacuum pump. Furthermore, to prevent contamination by impurities such as oxygen, the target surface was cleaned immediately after target installation and immediately before each film deposition experiment.

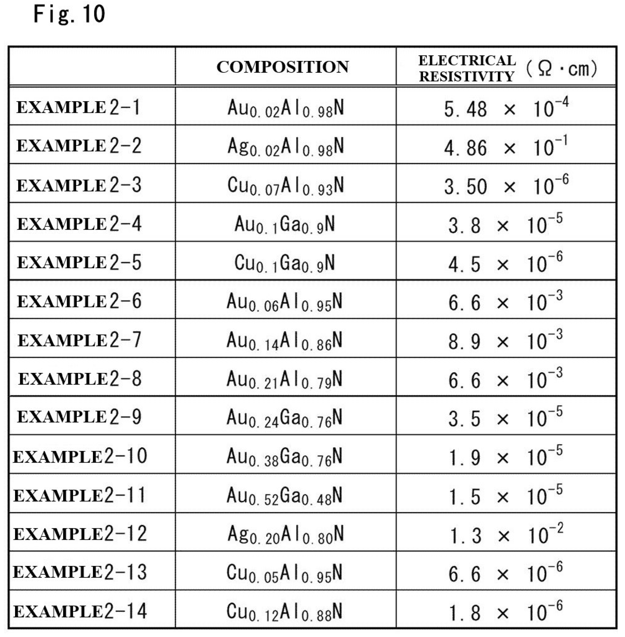

Fig. 10 shows the composition and electrical resistivity of each of the obtained nitride materials. From this diagram, it was found that the electrical resistivity of each of the nitride materials is 1.0 Ω·cm or lower.

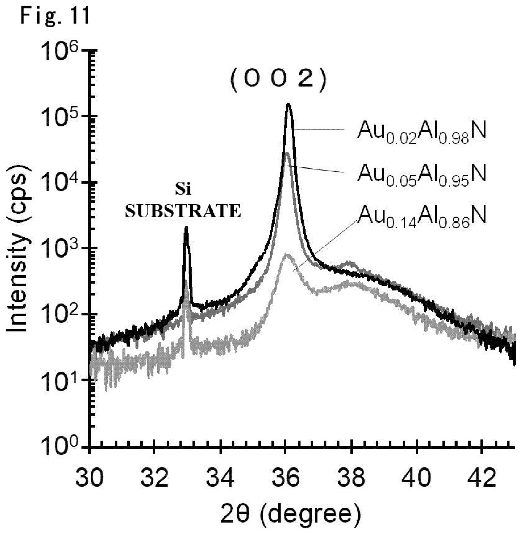

Further, Fig. 11 shows measurement results from the X-ray diffractometer (XRD) for Example 2-1 (Au_{0.02}Al_{0.98}N), Au_{0.05}Al_{0.95}N, and Au_{0.14}Al_{0.86}N. As can be seen from this diagram, it was found that the respective nitride materials of Example 2-1, Au_{0.05}Al_{0.95}N, and Au_{0.14}Al_{0.86}N have the wurtzite crystal structure.

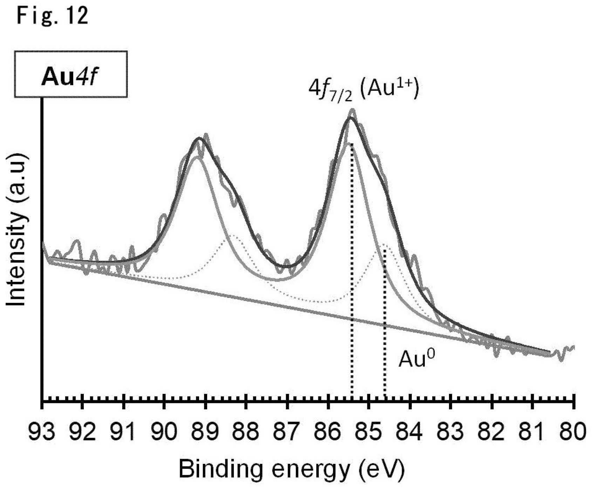

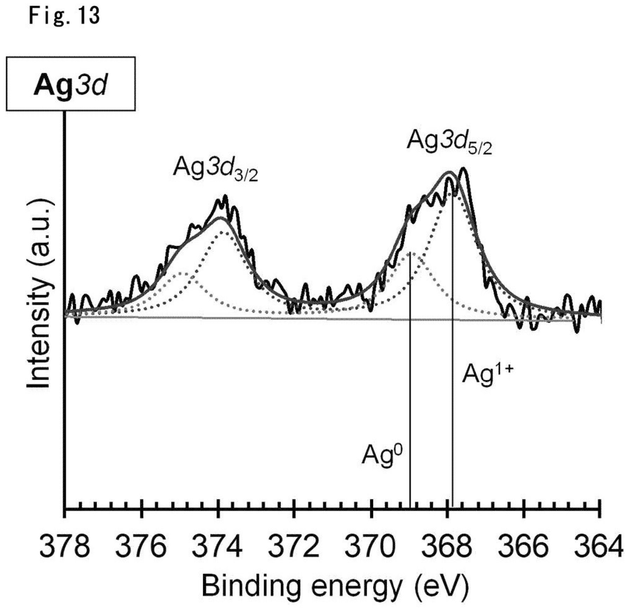

Furthermore, Figs. 12 and 13 each show a relationship between binding energy and intensity when the nitride materials of Examples 2-1 and 2-2 were measured using XPS (manufactured by Shimadzu/Kratos Analytical, AXIS-165).

From Fig. 12, it was found that the nitride material of Example 2-1 contains monovalent Au, and that monovalent Au is contained in the highest amount compared to Au with a valence other than 1 (Au with a valence of zero).

Further, from Fig. 13, it was found that the nitride material of Example 2-2 contains monovalent Ag, and that monovalent Ag is contained in the highest amount compared to Ag with a valence other than 1 (Ag with a valence of zero).

### <Band gap>

The band gap of the nitride material (Au_{0.0625}Al_{0.9375}N) according to the present embodiment was calculated via simulation. As in Embodiment 1, the VASP software was used for this simulation.

The simulation of the present embodiment used a wurtzite crystal structure of a supercell composed of 16 aluminum atoms and 16 nitrogen atoms, obtained by doubling a unit cell, which is composed of two aluminum atoms and two nitrogen atoms, along each of a, b, and c axes for the simulation.

Calculations were performed employing the wurtzite crystal structure in which, within a unit cell composed of 16 Al atoms and 16 N atoms, one Al atom was replaced with an Au atom. Then, for the model of this wurtzite crystal structure, the first-principles calculation was performed by simultaneously varying the atomic coordinates, cell volume, and cell shape to calculate an electronic state of a stable structure.

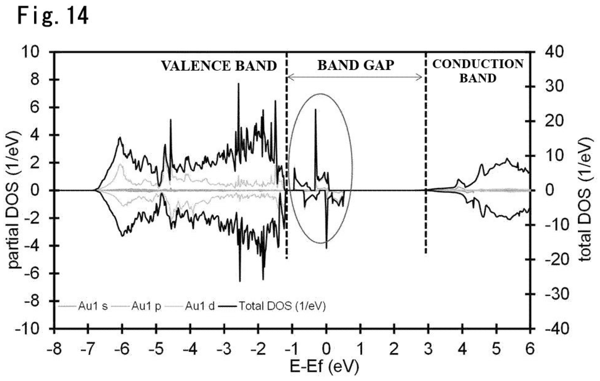

The results are shown in Fig. 14. Note that "E-Ef" on the horizontal axis of this diagram indicates energy levels relative to the Fermi energy (Ef). These results show that there is an acceptor level, which is the density of states (DOS) originating from impurities (Au), at an energy level slightly higher than a valence band of AlN.

As mentioned above, it is known that in semiconductor materials, a DOS (acceptor level) originating from an impurity (an added element) is formed at an energy level slightly higher than the valence band. From this, it can be seen that the nitride material (Au_{0.0625}Al_{0.9375}N) exhibits semiconductor properties.

Note that the nitride material according to the present embodiment is produced by doping (adding) AlN or GaN, which is a base material, with at least one of Au, Ag, and Cu. That is, it is produced by doping a trivalent element Al or Ga contained in AlN or GaN, which is the base material, with at least one of monovalent elements Au, Ag, and Cu. As a result, holes are generated, whereby the nitride material according to the present embodiment becomes a p-type semiconductor.

### (Other embodiments)

In the above-described Embodiment 1, Mg or Zn is used as A1, but the present invention is not limited thereto. For example, the nitride material may be composed such that Mg and Zn are contained as A1 in predetermined proportions. Even when the nitride material is composed in this manner, advantageous effects similar to those of Embodiment 1 can be obtained.

Similarly, in Embodiment 1 or 2, Au, Ag, or Cu is used as B1 and B2, but the present invention is not limited thereto. For example, the nitride material may be composed such that two of Au, Ag, and Cu are contained as B1 or B2 in predetermined proportions, or the nitride material may be composed such that Au, Ag, and Cu are contained in predetermined proportions. Even when the nitride material is composed in this manner, advantageous effects similar to those of Embodiment 1 can be obtained.

Furthermore, a diode may be configured using the nitride material according to the present invention. As long as the diode is the one using the nitride material according to the present invention, its configuration is not particularly limited and a well-known configuration may be employed. Examples of the configuration of the diode include those composed of the nitride material according to the present invention and an n-type semiconductor material (a semiconductor material in which electrical conduction occurs due to free electrons carrying a negative charge) joined to this nitride material. A diode having such a configuration exhibits a high dielectric breakdown field strength (for example, 2 MV/cm or higher) compared to a diode using a semiconductor material based on Si. Note that, as for the n-type semiconductor material, materials exhibiting a high dielectric breakdown field strength (for example, 2 MV/cm or higher), such as n-type GaN, n-type AlGaN, and n-type SiGaN, can be used, for example.

Furthermore, a transistor may be configured using the nitride material according to the present invention. As long as the transistor is the one using the nitride material according to the present invention, its configuration is not particularly limited and a well-known configuration may be employed. Examples of the configuration of the transistor include those composed of the nitride material according to the present invention and two n-type semiconductor materials (semiconductor materials in which electrical conduction occurs due to free electrons carrying a negative charge) joined so as to sandwich the nitride material, or those composed of an n-type semiconductor material and two nitride materials according to the present invention joined so as to sandwich the n-type semiconductor material. A transistor having such a configuration exhibits a high dielectric breakdown field strength (for example, 2 MV/cm or higher) compared to a transistor using a p-type semiconductor material based on Si. Note that, as for the n-type semiconductor material, materials exhibiting a high dielectric breakdown field strength (for example, 2 MV/cm or higher), such as n-type GaN, n-type AlGaN, and n-type SiGaN, can be used, for example.

## Claims

1. A nitride material,
represented by a chemical formula A1_{α1}B1_{β1}Al_{1-α1-β1}N or a chemical formula A1_{α1}B1_{β1}Ga_{1-α1-β1}N, α1 and β1 satisfying the following equation (1),
or
represented by a chemical formula B2_{β2}Al_{1-β2}N or a chemical formula B2_{β2}Ga_{1-β2}N, β2 satisfying the following equation (2),
B1 and B2 including a monovalent element, $0 < α 1 + β 1 < 1$ (1), $0 < β 2 < 1$ (2),
(0 < α1 < 1, 0 < β1 < 1, A1 is at least one of Mg and Zn, and B1 and B2 are at least one of Au, Ag, and Cu).

2. The nitride material according to claim 1, wherein
the α1 and the β1 satisfy the following equation (3), and
the β2 satisfies the following equation (4), $0 < α 1 / β 1 < 6$ (3), $0 < β 2 < 0.52$ (4).

3. The nitride material according to claim 1, wherein
B1 with a valence of 1 is contained in a highest amount compared to B1 with a valence other than 1, or B2 with a valence of 1 is contained in a highest amount compared to B2 with a valence other than 1.

4. The nitride material according to claim 1, wherein
a crystal structure is a wurtzite crystal structure.

5. The nitride material according to claim 1, wherein
the α1 and the β1 satisfy the following equations (5) and (6), $1 \leq α 1 / β 1 \leq 5$ (5), $0 < α 1 + β 1 \leq 0.3$ (6).

6. The nitride material according to any one of claims 1 to 5, wherein
an electrical resistivity is 10.0 Ω·cm or lower.

7. The nitride material according to any one of claims 1 to 5, wherein
an electrical resistivity is 1.0 Ω·cm or lower.

8. A diode comprising:
the nitride material according to claim 1 and an n-type semiconductor material joined to the nitride material.

9. A transistor comprising the nitride material according to claim 1 and two n-type semiconductor materials joined to the nitride material, or comprising an n-type semiconductor material and two pieces of the nitride material according to claim 1 joined to the n-type semiconductor material.

## Amended claims

### Amended claims in accordance with Rule 137(2) EPC.

1. **(Amended)** A nitride material,
represented by a chemical formula A1_{α1}B1_{β1}Al_{1-α1-β1}N or a chemical formula A1_{α1}B1_{β1}Ga_{1-α1-β1}N, α1 and β1 satisfying the following equation (1),
or
represented by a chemical formula B2_{β2}Al_{1-β2}N or a chemical formula B2_{β2}Ga_{1-β2}N, β2 satisfying the following equation (2),
B1 and B2 including a monovalent element, B1 with a valence of 1 is contained in a highest amount compared to B1 with a valence other than 1, or B2 with a valence of 1 is contained in a highest amount compared to B2 with a valence other than 1, $0 < α 1 + β 1 < 1$ (1), $0 < β 2 < 1$ (2),
(0 < α1 < 1, 0 < β1 < 1, A1 is at least one of Mg and Zn, and B1 and B2 are at least one of Au, Ag, and Cu).

2. The nitride material according to claim 1, wherein
the α1 and the β1 satisfy the following equation (3), and
the β2 satisfies the following equation (4), $0 < α 1 / β 1 < 6$ (3), $0 < β 2 < 0.52$ (4).

3. **(Amended)** The nitride material according to claim 1, wherein
a crystal structure is a wurtzite crystal structure.

4. **(Amended)** The nitride material according to claim 1, wherein
the α1 and the β1 satisfy the following equations (5) and (6), $1 \leq α 1 / β 1 \leq 5$ (5), $0 < α 1 + β 1 \leq 0.3$ (6).

5. **(Amended)** The nitride material according to claim 1, wherein
an electrical resistivity is 10.0 Ω·cm or lower.

6. **(Amended)** The nitride material according to claim 2, wherein
an electrical resistivity is 10.0 Ω·cm or lower.

7. **(Amended)** The nitride material according to claim 3, wherein
an electrical resistivity is 10.0 Ω·cm or lower.

8. **(Added)** The nitride material according to claim 4, wherein
an electrical resistivity is 10.0 Ω·cm or lower.

9. **(Added)** The nitride material according to claim 1, wherein
an electrical resistivity is 1.0 Ω·cm or lower.

10. **(Added)** The nitride material according to claim 2, wherein
an electrical resistivity is 1.0 Ω·cm or lower.

11. **(Added)** The nitride material according to claim 3, wherein
an electrical resistivity is 1.0 Ω·cm or lower.

12. **(Added)** The nitride material according to claim 4, wherein
an electrical resistivity is 1.0 Ω·cm or lower.

13. **(Amended)** A diode comprising:
the nitride material according to claim 1 and an n-type semiconductor material joined to the nitride material.

14. **(Amended)**
A transistor comprising:
the nitride material according to claim 1 and two n-type semiconductor materials joined to the nitride material, or comprising an n-type semiconductor material and two pieces of the nitride material according to claim 1 joined to the n-type semiconductor material.

Statement under Art. 19.1 PCT
Claim 1 has been clarified to indicate that monovalent B1 is contained in the largest amount compared to B1 having valences other than 1, or monovalent B2 is contained in the largest amount compared to B2 having valences other than 1.

Cited Document 1 describes, in an invention of an AlN nitride used for a piezoelectric nitride, co-doping AlN with Mg and a substitution element (wherein M is any one of Cr, Mn, Fe, Co, Ni, Mo, Tc, Ru, Rh, Pd, Ag, W, Os, Ir, Pt, and Au), that the AlN nitride has a chemical formula such as Mg0.0625Cu0.0625Al0.875, and that undoped AlN has a wurtzite crystal structure; however, it neither discloses nor suggests the valence of the substitution element contained in the AlN nitride.

As described above, the present invention achieves the effect of having lower electrical resistivity and exhibiting semiconductor properties, by containing monovalent B1 in the largest amount compared to B1 having valences other than 1, or by containing monovalent B2 in the largest amount compared to B2 having valences other than 1.
